# EUROPEAN PATENT APPLICATION

(11) **EP 2 355 194 A2**
(43) Date of publication of application: **10.08.2011**
(21) Application number: 11152603.4
(22) Date of filing: 28.01.2011
(51) Int. Cl.: H01L 33/48, H01L 33/56, H01L 33/50, H01L 33/58, H01L 33/60

(54) **Light emitting device package**

(30) Priority: 28.01.2010 KR 20100008151
(71) Applicant: LG Innotek Co., Ltd., Seoul 100-714 (KR)
(72) Inventor: Kim, Deung Kwan, 100-714, Seoul (KR)
(74) Representative: Zardi, Marco

(57) **Abstract**

A light emitting device package according to the embodiment includes a package body (110,210); a light emitting device (120,220) over the package body (110,210); a first molding member (130,230) having a first refractive index over the light emitting device (120,220); and a second molding member (140,141,143,145,240,241,243,245) having a second refractive index lower than the first refractive index over the first molding member (130,230). A light emitting device package according to another embodiment includes a package body (310); a light emitting device (320) over the package body (310); a resin layer (330) including fluorescent materials; a first molding member (340,341) having a first refractive index over the resin layer (330); and a second molding member (350,351,353,355,357,359) having a second refractive index lower than the first refractive index over the first molding member (340,341).

## Description

### FIELD OF THE APPLICATION

The disclosure relates to a light emitting device package.

### PRIOR ART

A light emitting diode (LED) is a semiconductor light emitting device that converts current into light. A wavelength of light emitted from the LED may vary depending on a semiconductor material used for manufacturing the LED. This is because the wavelength of the emitted light varies depending on the bandgap of the semiconductor material, that is, the energy difference between valance band electrons and conduction band electrons.

The LED can generate light having high brightness, so that the LED has been expansively used as a light source for a display device, a vehicle, or a lighting device. In addition, the LED can represent a white color having superior light efficiency by employing luminescence materials or combining LEDs having various colors.

Such an LED can be prepared in the form of a light emitting device (LED) package and various studies have been conducted to improve the light extraction efficiency of the LED. In many LED packages, since the LED chip is disposed in the cavity of the package body and covered by a layer which comprises materials whose refractive index is different from that of the air, a substantial amount of light which is emitted by the LED chip and transmitted through the layer is reflected back against the surface of the layer into the cavity, which lowers light extraction efficiency.

### SUMMARY OF THE INVENTION

The present invention provides a light emitting device package capable of improving the light extraction efficiency.

A light emitting device package according to an aspect of the invention may include a package body; a light emitting device over the package body; a first molding member having a first refractive index surrounding at least partially the light emitting device; and a second molding member having a second refractive index lower than the first refractive index over the first molding member. Since the light extraction efficiency can be improved when the light is transmitted from a dense medium to a rough medium, if the optical system is designed in such a manner that the light can be gradually transmitted from the dense medium to the rough medium without being subject to steep change of the refractive index, the light extraction efficiency can be improved. Due to the constitution of the two molding member which have different refractive index of the invention, the light extraction efficiency can be improved.

According to another aspect of the invention, the light emitting device package further comprises a third molding member having a third refractive index lower than the second refractive index over the second molding member. The second molding member may have a planar top surface. Alternatively, the second molding member may have a lens-shape top surface.

According to another aspect of the invention, the light emitting device includes at least one selected from the group consisting of red light emitting device, green light emitting device, blue light emitting device, and white light emitting device..

According to another aspect of the invention, the light emitting device package further comprises fixing member surrounding the second molding member. The light emitting device further comprises a fluorescent layer disposed over the light emitting device. The light emitting device may emits light having a wavelength band of ultraviolet ray.

According to another aspect of the invention, the light emitting device is disposed in a cavity formed in the package body and the cavity has a step structure corresponding to the step structure between the first and second molding members.

According to another aspect of the invention, a light emitting device package comprises a package body; a light emitting device over the package body; a resin layer including fluorescent materials, the resin layer at least partially surrounding the light emitting device; a first molding member having a first refractive index over the resin layer; and a second molding member having a second refractive index lower than the first refractive index over the first molding member, wherein the first molding member has a step structure with respect to the second molding member.

According to another aspect of the invention, the fluorescent materials emit light having a different wavelength band from the wavelength band of the light that the light emitting device emits. The light emitting device may emit light having a wavelength band of ultraviolet ray.

### BRIEF DESCRIPTION OF THE DRAWINGS

FIG. 1 is a sectional view showing a light emitting device package according to the embodiment;
FIGS. 2 to 7 are sectional views showing modified examples of a light emitting device package of FIG. 1;
FIG. 8 is a sectional view showing a light emitting device package according to another embodiment;
FIGS. 9 to 14 are sectional views showing modified examples of a light emitting device package of FIG. 8;
FIG. 15 is a sectional view showing a light emitting device package according to still another embodiment; and
FIGS. 16 to 21 are sectional views showing modified examples of a light emitting device package of FIG. 15.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" over the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, the light emitting device package according to embodiments will be described with reference to accompanying drawings.

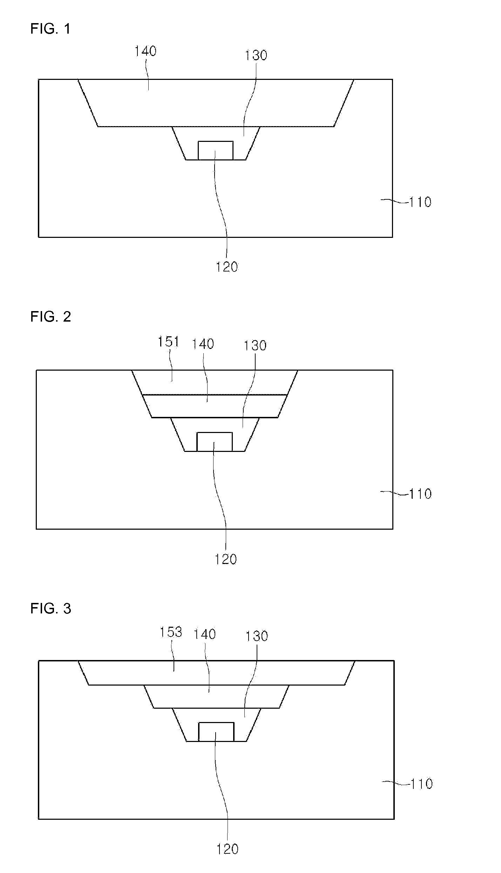

FIG. 1 is a sectional view showing a light emitting device package according to the embodiment.

The light emitting device package according to the embodiment includes a package body 110, a light emitting device 120, a first molding member 130 and a second molding member 140.

The light emitting device 120 is installed on the package body 110. The light emitting device 120 includes a light emitting diode (LED). One or plural light emitting devices 120 can be installed on the package body 110. For instance, the light emitting device 120 may include at least one red light emitting device, at least one green light emitting device and at least one blue light emitting device in order to provide white light. In addition, the light emitting device 120 may further include a white light emitting device. The light emitting device 120 may include only the white light emitting device. The light emitting device 120 can be designed to emit the light having the wavelength band of ultraviolet ray.

The first molding member 130 can be designed to have a first refractive index. The second molding member 140 is disposed on the first molding member 130. The second molding member 140 can be designed to have a second refractive index lower than the first refractive index. For instance, the first molding member 130 may have the refractive index of 1.7, and the second molding member 140 may have the refractive index of 1.5.

According to the embodiment, the light generated from the light emitting device 120 is emitted to an air layer through the first and second molding members 130 and 140. At this time, since the first molding member 130 has the refractive index higher than that of the second molding member 140, the extraction efficiency of the light transmitted from the first molding member 130 to the second molding member 140 can be improved. In addition, the second molding member 140 has the refractive index higher than that of the external air layer, so the extraction efficiency of the light transmitted from the second molding member 140 to the air layer can be improved. Since the light extraction efficiency can be improved when the light is transmitted from a dense medium to a rough medium, if the optical system is designed in such a manner that the light can be gradually transmitted from the dense medium to the rough medium without being subject to abrupt change of the refractive index, the light extraction efficiency can be improved.

The second molding member 140 may have a planar top surface. In addition, the second molding member 140 may have a lens-shape top surface. That is, the top surface of the second molding member 140 may have a concave lens shape, a convex lens shape or an aspheric lens shape to adjust the orientation angle of the light.

According to the embodiment, a third molding member can be further formed on the second molding member 140. In this case, the third molding member is designed to have a third refractive index lower than the second refractive index of the second molding member 140.

Referring to the embodiment shown in FIG. 1, a step portion is formed in a cavity of the package body 110. That is, the lateral side of the cavity formed in the package body 110 is not configured as the straight line, but the step portion is formed between the first molding member 130 and the second molding member 140. However, according to the embodiment, the cavity of the package body 110 may have the step portion or not.

Hereinafter, modified examples of the embodiment will be described with reference to FIGS. 2 to 7. The following description will be focused on difference with respect to FIG. 1, and the technical scope of the embodiment is not limited to those shown in the drawings.

According to the embodiment, as shown in FIG. 2, the second molding member 140 is formed on the first molding member 130 and a third molding member 151 is formed on the second molding member 140. The first molding member 130 is designed to have the refractive index higher than that of the second molding member 140, and the second molding member 140 is designed to have the refractive index higher than that of the third molding member 151.

According to the embodiment, as shown in FIG. 3, the second molding member 140 is formed on the first molding member 130 and a third molding member 153 is formed on the second molding member 140. The first molding member 130 is designed to have the refractive index higher than that of the second molding member 140, and the second molding member 140 is designed to have the refractive index higher than that of the third molding member 153. In addition, a bottom surface of the third molding member 153 is larger than a top surface of the second molding member 140. Further, the cavity of the package body 110 may have a step portion corresponding to the shape of the second and third molding members 140 and 153. For instance, as shown in FIG. 3, the cavity of the package body 110 may have a three-step structure.

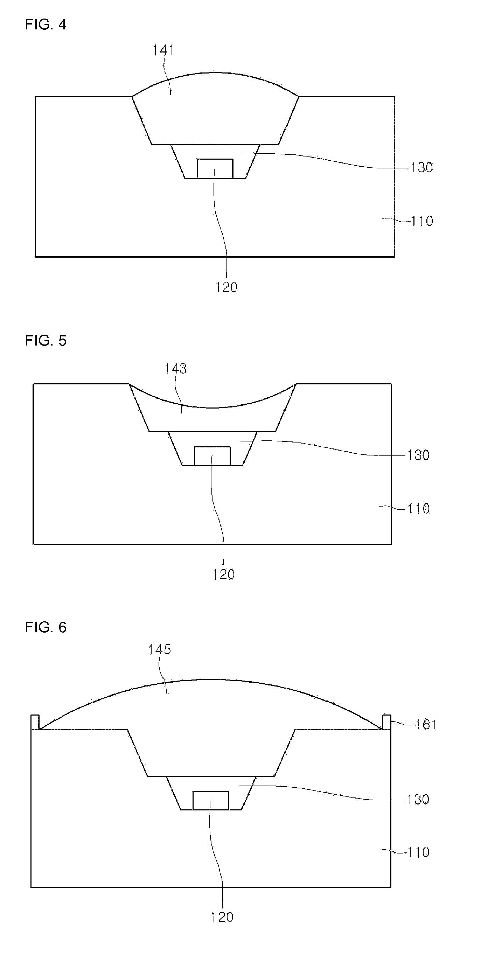

According to the embodiment, as shown in FIG. 4, a second molding member 141 is formed on the first molding member 130. The first molding member 130 is designed to have the refractive index higher than that of the second molding member 141. A top surface of the second molding member 141 may have a lens shape. For instance, the top surface of the second molding member 141 may have a convex lens shape.

According to the embodiment, as shown in FIG. 5, a second molding member 143 is formed on the first molding member 130. The first molding member 130 is designed to have the refractive index higher than that of the second molding member 143. A top surface of the second molding member 143 may have a lens shape. For instance, the top surface of the second molding member 143 may have a concave lens shape.

According to the embodiment, as shown in FIG. 6, a second molding member 145 is formed on the first molding member 130. The first molding member 130 is designed to have the refractive index higher than that of the second molding member 145. A top surface of the second molding member 145 may have a lens shape. For instance, the top surface of the second molding member 145 may have a convex lens shape. In addition, the second molding member 145 may be formed over the whole area of a top surface of the package body 110. A fixing member 161 can be provided at the outer peripheral portion of the second molding member 145 on the top surface of the package body 110. For instance, the fixing member 161 can be formed through a silk screen scheme. The fixing member 161 can guide the position of the second molding member 145. The fixing member 161 may be formed by using resin or ink.

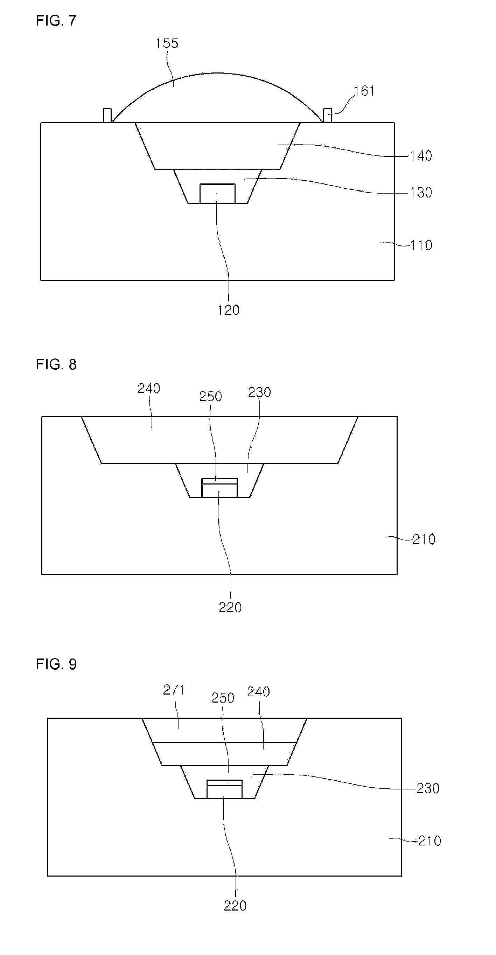

According to the embodiment, as shown in FIG. 7, the second molding member 140 is formed on the first molding member 130 and a third molding member 155 is formed on the second molding member 140. The first molding member 130 is designed to have the refractive index higher than that of the second molding member 140, and the second molding member 140 is designed to have the refractive index higher than that of the third molding member 155. A top surface of the third molding member 155 may have a lens shape. For instance, the top surface of the third molding member 155 may have a convex lens shape. In addition, the third molding member 155 may be formed on a part of the top surface of the package body 110. The fixing member 161 can be provided at the outer peripheral portion of the third molding member 155. For instance, the fixing member 161 can be formed through a silk screen scheme. The fixing member 161 can guide the position of the third molding member 155. The fixing member 161 may be formed by using resin or ink.

FIG. 8 is a sectional view showing a light emitting device package according to another embodiment.

The light emitting device package according to another embodiment includes a package body 210, a light emitting device 220, a first molding member 230, a second molding member 240, and a fluorescent layer 250.

The light emitting device 220 is installed on the package body 210. The light emitting device 320 includes a light emitting diode (LED). One or plural light emitting devices 220 can be installed on the package body 210. For instance, the light emitting device 220 may include a red light emitting device, a green light emitting device, a blue light emitting device and a white light emitting device. In addition, the light emitting device 220 can be designed to emit the light having the wavelength band of ultraviolet ray.

The fluorescent layer 250 is disposed on the light emitting device 220. The light emitting device 220 can be designed to emit the light having the first wavelength band. The fluorescent layer 250 can be designed to emit the light having the second wavelength band by receiving the light having the first wavelength band from the light emitting device 220. As a result, the white light is emitted through the combination of the light emitted from the light emitting device 220 and the light emitted from the fluorescent layer 250.

The first molding member 230 is disposed on the light emitting device 220 and the fluorescent layer 250. The first molding member 230 can be designed to have a first refractive index. The second molding member 240 is disposed on the first molding member 230. The second molding member 240 can be designed to have a second refractive index lower than the first refractive index. For instance, the first molding member 230 may have the refractive index of 1.7, and the second molding member 240 may have the refractive index of 1.5.

According to the embodiment, the light generated from the light emitting device 220 is emitted to an air layer through the first and second molding members 230 and 240. At this time, since the first molding member 230 has the refractive index higher than that of the second molding member 240, the extraction efficiency of the light transmitted from the first molding member 230 to the second molding member 240 can be improved. In addition, the second molding member 240 has the refractive index higher than that of the external air layer, so the extraction efficiency of the light transmitted from the second molding member 240 to the air layer can be improved. Since the light extraction efficiency is improved when the light is transmitted from a dense medium to a rough medium, if the optical system is designed in such a manner that the light can be gradually transmitted from the dense medium to the rough medium without being subject to steep change of the refractive index, the light extraction efficiency can be improved.

The second molding member 240 may have a planar top surface. In addition, the second molding member 240 may have a lens-shape top surface. That is, the top surface of the second molding member 240 may have a concave lens shape, a convex lens shape or an aspheric lens shape to adjust the orientation angle of the light.

According to the embodiment, a third molding member can be further formed on the second molding member 240. In this case, the third molding member is designed to have a third refractive index lower than the second refractive index of the second molding member 240.

Referring to the embodiment shown in FIG. 8, a step portion is formed in a cavity of the package body 210. That is, the lateral side of the cavity formed in the package body 210 is not configured as the straight line, but the step portion is formed between the first molding member 230 and the second molding member 240. However, according to the embodiment, the cavity of the package body 210 may have the step portion or not.

Hereinafter, modified examples of another embodiment will be described with reference to FIGS. 9 to 14. The following description will be focused on difference with respect to FIG. 8, and the technical scope of the embodiment is not limited to those shown in the drawings.

According to the embodiment, as shown in FIG. 9, the second molding member 240 is formed on the first molding member 230 and a third molding member 271 is formed on the second molding member 240. The first molding member 230 is designed to have the refractive index higher than that of the second molding member 240, and the second molding member 240 is designed to have the refractive index higher than that of the third molding member 271.

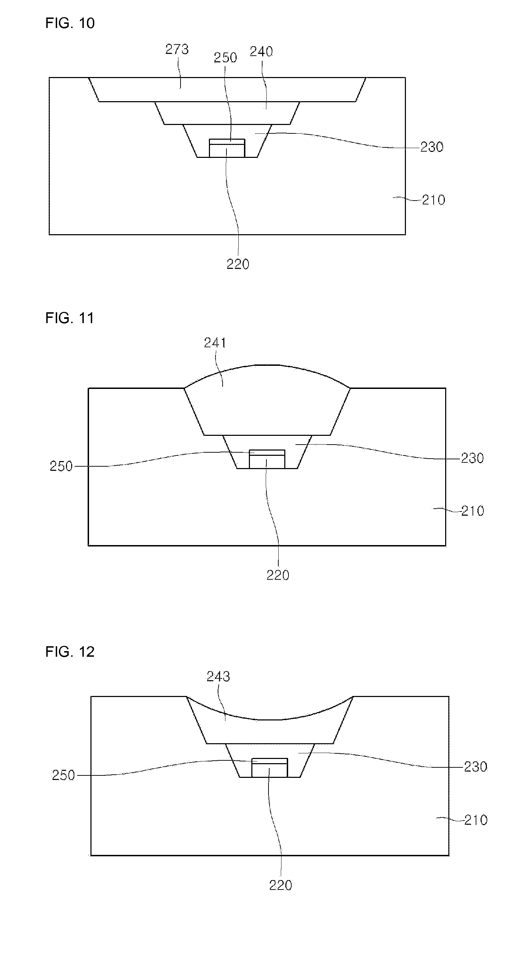

According to the embodiment, as shown in FIG. 10, the second molding member 240 is formed on the first molding member 230 and a third molding member 273 is formed on the second molding member 240. The first molding member 230 is designed to have the refractive index higher than that of the second molding member 240, and the second molding member 240 is designed to have the refractive index higher than that of the third molding member 273. In addition, a bottom surface of the third molding member 273 is larger than a top surface of the second molding member 240. Further, the cavity of the package body 210 may have a step portion corresponding to the shape of the second and third molding members 240 and 273. For instance, as shown in FIG. 10, the cavity of the package body 210 may have a three-step structure.

According to the embodiment, as shown in FIG. 11, a second molding member 241 is formed on the first molding member 230. The first molding member 230 is designed to have the refractive index higher than that of the second molding member 241. A top surface of the second molding member 241 may have a lens shape. For instance, the top surface of the second molding member 241 may have a convex lens shape.

According to the embodiment, as shown in FIG. 12, a second molding member 243 is formed on the first molding member 230. The first molding member 230 is designed to have the refractive index higher than that of the second molding member 243. A top surface of the second molding member 243 may have a lens shape. For instance, the top surface of the second molding member 243 may have a concave lens shape.

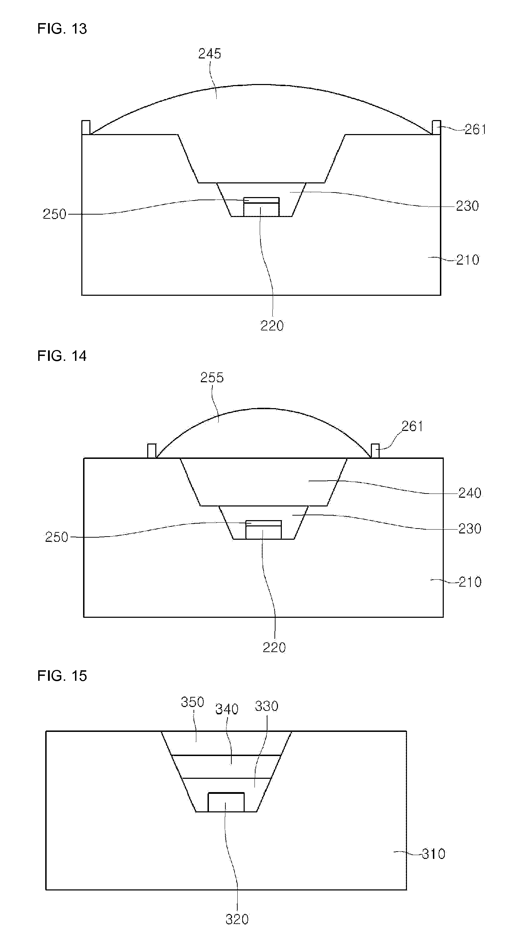

According to the embodiment, as shown in FIG. 13, a second molding member 245 is formed on the first molding member 230. The first molding member 230 is designed to have the refractive index higher than that of the second molding member 245. A top surface of the second molding member 245 may have a lens shape. For instance, the top surface of the second molding member 245 may have a convex lens shape. In addition, the second molding member 245 may be formed over the whole area of a top surface of the package body 210. A fixing member 261 can be provided at the outer peripheral portion of the second molding member 245 on the top surface of the package body 210. For instance, the fixing member 261 can be formed through a silk screen scheme. The fixing member 261 can guide the position of the second molding member 245. The fixing member 161 may be formed by using resin or ink.

According to the embodiment, as shown in FIG. 14, the second molding member 240 is formed on the first molding member 230 and a third molding member 255 is formed on the second molding member 240. The first molding member 230 is designed to have the refractive index higher than that of the second molding member 240, and the second molding member 240 is designed to have the refractive index higher than that of the third molding member 255. A top surface of the third molding member 255 may have a lens shape. For instance, the top surface of the third molding member 255 may have a convex lens shape. In addition, the third molding member 255 may be formed on a part of the top surface of the package body 210. The fixing member 261 can be provided at the outer peripheral portion of the third molding member 255. For instance, the fixing member 261 can be formed through a silk screen scheme. The fixing member 261 can guide the position of the third molding member 255. The fixing member 261 may be formed by using resin or ink.

FIG. 15 is a sectional view showing a light emitting device package according to still another embodiment.

The light emitting device package according to still another embodiment includes a package body 310, a light emitting device 320, a resin layer 330, a first molding member 340, and a second molding member 350.

The light emitting device 320 is installed on the package body 310. The light emitting device 320 includes a light emitting diode (LED). One or plural light emitting devices 320 can be installed on the package body 310. For instance, the light emitting device 320 may include a red light emitting device, a green light emitting device, a blue light emitting device and a white light emitting device. In addition, the light emitting device 320 can be designed to emit the light having the wavelength band of ultraviolet ray.

The resin layer 330 including fluorescent materials is disposed on the light emitting device 320. The light emitting device 320 can be designed to emit the light having the first wavelength band. The resin layer 330 including the fluorescent materials emits the light having the second wavelength band by receiving the light having the first wavelength band from the light emitting device 320. As a result, the white light is emitted through the combination of the light emitted from the light emitting device 320 and the light emitted from the resin layer 330 including the fluorescent materials.

The first molding member 340 is disposed on the resin layer 330. The first molding member 340 can be designed to have a first refractive index. The second molding member 350 is disposed on the first molding member 340. The second molding member 350 can be designed to have a second refractive index lower than the first refractive index. The resin layer 330 can be designed to have a refractive index higher than the refractive index of the first molding par 340. For instance, the first molding member 340 may have the refractive index of 1.7, and the second molding member 350 may have the refractive index of 1.5.

According to the embodiment, the light generated from the light emitting device 320 is emitted to an air layer through the first and second molding members 340 and 350. At this time, since the first molding member 340 has the refractive index higher than that of the second molding member 350, the extraction efficiency of the light transmitted from the first molding member 340 to the second molding member 350 can be improved. In addition, the second molding member 350 has the refractive index higher than that of the external air layer, so the extraction efficiency of the light transmitted from the second molding member 350 to the air layer can be improved. Since the light extraction efficiency is improved when the light is transmitted from a dense medium to a rough medium, if the optical system is designed in such a manner that the light can be gradually transmitted from the dense medium to the rough medium without being subject to steep change of the refractive index, the light extraction efficiency can be improved.

The second molding member 350 may have a planar top surface. In addition, the second molding member 350 may have a lens-shape top surface. That is, the top surface of the second molding member 350 may have a concave lens shape, a convex lens shape or an aspheric lens shape to adjust the orientation angle of the light.

According to the embodiment, a third molding member can be further formed on the second molding member 350. In this case, the third molding member is designed to have a third refractive index lower than the second refractive index of the second molding member 350.

Referring to the embodiment shown in FIG. 15, a step portion is not formed in a cavity of the package body 310. That is, the lateral side of the cavity formed in the package body 310 is configured as the straight line. However, according to the embodiment, the cavity of the package body 310 may have the step portion or not.

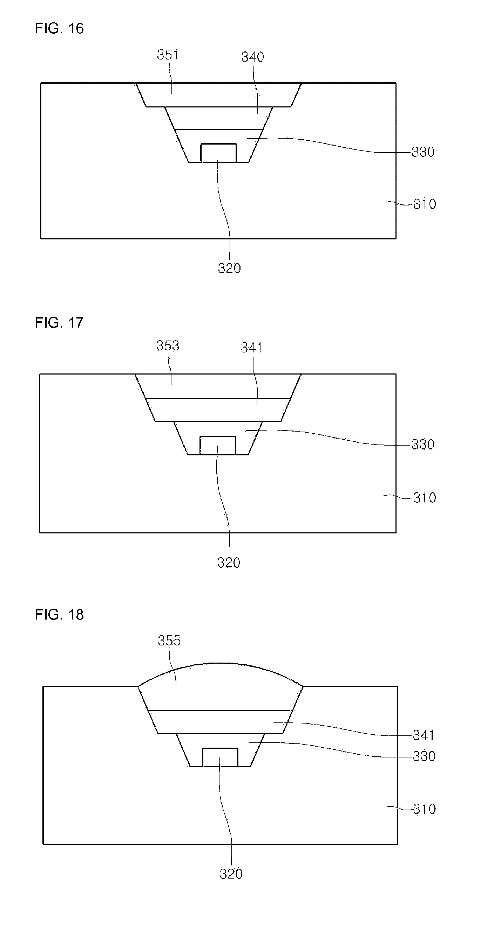

Hereinafter, modified examples of another embodiment will be described with reference to FIGS. 16 to 21. The following description will be focused on difference with respect to FIG. 15, and the technical scope of the embodiment is not limited to those shown in the drawings.

According to the embodiment, as shown in FIG. 16, a second molding member 351 is formed on the first molding member 340. The first molding member 340 is designed to have the refractive index higher than that of the second molding member 351. In addition, a bottom surface of the second molding member 351 is larger than a top surface of the first molding member 340. Further, the cavity of the package body 310 may have a step portion corresponding to the shape of the second and third molding members 340 and 351. For instance, as shown in FIG. 16, the cavity of the package body 310 may have a two-step structure.

According to the embodiment, as shown in FIG. 17, a second molding member 353 is formed on a first molding member 341. The first molding member 341 is designed to have the refractive index higher than that of the second molding member 353. In addition, the size of a bottom surface of the second part 353 is identical to the size of a top surface of the first molding member 341. Further, a bottom surface of the first molding member 341 is larger than a top surface of the resin layer 330. The cavity of the package body 310 may have a step portion corresponding to the shape of the first and second molding members 341 and 353 and the resin layer 330. For instance, as shown in FIG. 17, the cavity of the package body 210 may have a two-step structure.

According to the embodiment, as shown in FIG. 18, a second molding member 355 is formed on the first molding member 341. The first molding member 341 is designed to have the refractive index higher than that of the second molding member 355. A top surface of the second molding member 355 may have a lens shape. For instance, the top surface of the second molding member 355 may have a convex lens shape.

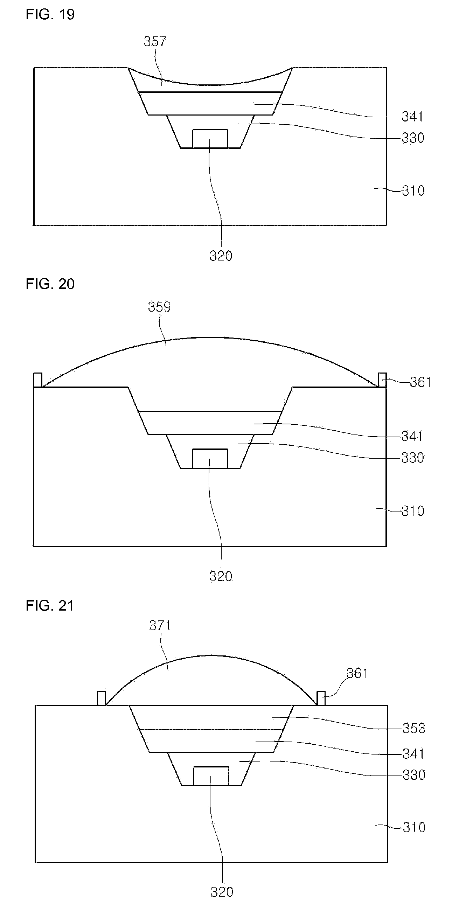

According to the embodiment, as shown in FIG. 19, a second molding member 357 is formed on the first molding member 341. The first molding member 341 is designed to have the refractive index higher than that of the second molding member 357. A top surface of the second molding member 357 may have a lens shape. For instance, the top surface of the second molding member 357 may have a concave lens shape.

According to the embodiment, as shown in FIG. 20, a second molding member 359 is formed on the first molding member 341. The first molding member 341 is designed to have the refractive index higher than that of the second molding member 359. A top surface of the second molding member 359 may have a lens shape. For instance, the top surface of the second molding member 359 may have a convex lens shape. In addition, the second molding member 359 may be formed over the whole area of a top surface of the package body 310. A fixing member 361 can be provided at the outer peripheral portion of the second molding member 359 on the top surface of the package body 310. For instance, the fixing member 361 can be formed through a silk screen scheme. The fixing member 361 can guide the position of the second molding member 359. The fixing member 361 may be formed by using resin or ink.

According to the embodiment, as shown in FIG. 21, the second molding member 353 is formed on the first molding member 341 and a third molding member 371 is formed on the second molding member 353. The first molding member 341 is designed to have the refractive index higher than that of the second molding member 353, and the second molding member 353 is designed to have the refractive index higher than that of the third molding member 371. A top surface of the third molding member 371 may have a lens shape. For instance, the top surface of the third molding member 371 may have a convex lens shape. In addition, the third molding member 371 may be formed on a part of the top surface of the package body 310. The fixing member 361 can be provided at the outer peripheral portion of the third molding member 371. For instance, the fixing member 361 can be formed through a silk screen scheme. The fixing member 361 can guide the position of the third molding member 371. The fixing member 361 may be formed by using resin or ink.

The light emitting device according to the embodiments may serve as a lighting system such as a backlight unit, an indicator, a lamp or a streetlamp.

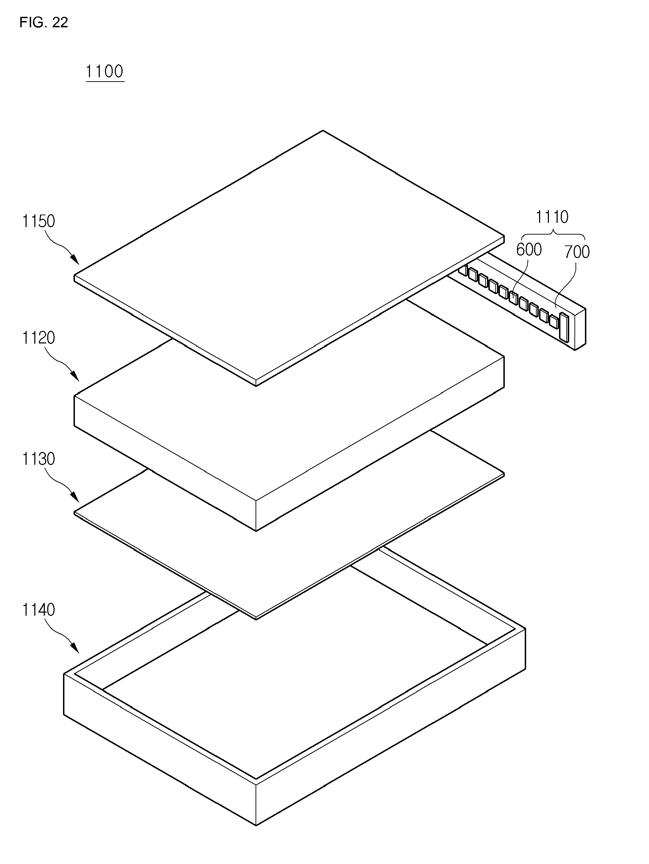

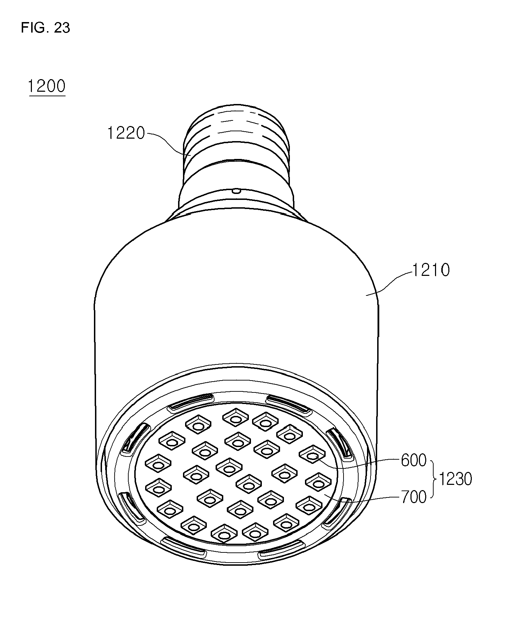

Hereinafter, applications of the disclosure will be described with reference to FIGS. 22 and 23.

FIG. 22 is a perspective view showing a backlight unit 1100 including the light emitting device according to the disclosure.

The backlight unit 1100 shown in FIG. 22 is an example of a lighting system and the embodiment is not limited thereto.

Referring to FIG. 22, the backlight unit 1100 includes a bottom cover 1140, a light guide member 1120, and a light emitting module 1110 installed at one side or on the bottom surface of the light guide member 1120. In addition, a reflective sheet 1130 is disposed under the light guide member 1120.

The bottom cover 1140 has a box shape having an open top surface to receive the light guide member 1120, the light emitting module 1110 and the reflective sheet 1130 therein. In addition, the bottom cover 1140 may include metallic material or resin material, but the embodiment is not limited thereto.

The light emitting module 1110 may include a plurality of light emitting devices 600 mounted on a substrate 700. The light emitting devices 600 provide the light to the light guide member 1120.

As shown in FIG. 22, the light emitting module 1110 is installed over at least one inner side of the bottom cover 1140 to provide the light to at least one side of the light guide member 1120.

In addition, the light emitting module 1110 can be provided under the light guide member 1120 in the bottom cover 1140 to provide the light toward the bottom surface of the light guide member 1120. Such an arrangement can be variously changed according to the design of the backlight unit 1100.

The light guide member 1120 is installed in the bottom cover 1140. The light guide member 1120 converts the light emitted from the light emitting module 1110 into the surface light to guide the surface light toward a display panel (not shown).

The light guide member 1120 may include a light guide plate. For instance, the light guide plate can be manufactured by using acryl-based resin, such as PMMA (polymethyl methacrylate), PET (polyethylene terephthalate), COC, PC (polycarbonate) or PEN (polyethylene naphthalate) resin.

An optical sheet 1150 may be provided over the light guide member 1120.

The optical sheet 1150 may include at least one of a diffusion sheet, a light collection sheet, a brightness enhancement sheet, and a fluorescent sheet. For instance, the optical sheet 1150 has a stack structure of the diffusion sheet, the light collection sheet, the brightness enhancement sheet, and the fluorescent sheet. In this case, the diffusion sheet uniformly diffuses the light emitted from the light emitting module 1110 such that the diffused light can be concentrated onto the display panel (not shown) by the light collection sheet. The light output from the light collection sheet is randomly polarized and the brightness enhancement sheet increases the degree of polarization of the light output from the light collection sheet. The light collection sheet may include a horizontal and/or vertical prism sheet. In addition, the brightness enhancement sheet may include a dual brightness enhancement film and the fluorescent sheet may include a transmittive plate or a transmittive film including fluorescent materials.

The reflective sheet 1130 can be disposed under the light guide member 1120. The reflective sheet 1130 reflects the light, which is emitted through the bottom surface of the light guide member 1120, toward the light exit surface of the light guide member 1120. The reflective sheet 1130 may include resin material having a high reflectance, such as PET, PC or PVC resin, but the embodiment is not limited thereto.

FIG. 23 is a perspective view showing a lighting system 1200 including the light emitting device according to the embodiment. The lighting system 1200 shown in FIG. 23 is only one example and the embodiment is not limited thereto.

Referring to FIG. 23, the lighting system 1200 includes a case body 1210, a light emitting module 1230 installed in the case body 1210, and a connection terminal 1220 installed in the case body 1210 to receive power from an external power source.

Preferably, the case body 1210 includes material having superior heat dissipation property. For instance, the case body 1210 includes metallic material or resin material.

The light emitting module 1230 may include a substrate 700 and at least one light emitting device 600 installed over the substrate 700.

The substrate 700 includes an insulating member printed with a circuit pattern. For instance, the substrate 700 includes a PCB (printed circuit board), an MC (metal core) PCB, a flexible PCB, or a ceramic PCB.

In addition, the substrate 700 may include material that effectively reflects the light. The surface of the substrate 700 can be coated with a color, such as a white color or a silver color, to effectively reflect the light.

At least one light emitting device 600 can be installed over the substrate 700.

Each light emitting device 600 may include at least one LED (light emitting diode). The LED may include a colored LED that emits the light having the color of red, green, blue or white and a UV (ultraviolet) LED that emits UV light.

The light emitting module 1230 can be variously arranged to provide various colors and brightness. For instance, the white LED, the red LED and the green LED can be combined to achieve the high color rendering index (CRI). In addition, a fluorescent sheet can be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may include yellow fluorescent material. In this case, the light emitted from the light emitting module 1230 passes through the fluorescent sheet so that the light is viewed as white light.

The connection terminal 1220 is electrically connected to the light emitting module 1230 to supply power to the light emitting module 1230. Referring to FIG. 23, the connection terminal 1220 has a shape of a socket screw-coupled with the external power source, but the embodiment is not limited thereto. For instance, the connection terminal 1220 can be prepared in the form of a pin inserted into the external power source or connected to the external power source through a wire.

According to the lighting system as described above, at least one of the light guide member, the diffusion sheet, the light collection sheet, the brightness enhancement sheet and the fluorescent sheet is provided in the path of the light emitted from the light emitting module, so that the desired optical effect can be achieved.

The backlight unit 1100 and the lighting system 1200 of FIGS. 22 and 23 include the light emitting modules 1110 and 1230 including the light emitting device of FIGS. 1 to 21, so that superior light efficiency can be acquired.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device package comprising:
a package body (110, 210);
a light emitting device (120, 220) in the package body (110, 210);
a first molding member (130, 230) having a first refractive index surrounding at least partially the light emitting device (120, 220); and
a second molding member (140, 141, 143, 145, 240, 241, 243, 245) having a second refractive index lower than the first refractive index disposed over the first molding member (130, 230),
wherein the first molding member (130, 230) has a step structure with respect to the second molding member (140, 141, 143, 145, 240, 241, 243, 245).

2. The light emitting device package of claim 1, further comprising a third molding member (151, 153, 155, 255, 271, 273) having a third refractive index lower than the second refractive index over the second molding member (140, 141, 143, 145,240,241,243,245).

3. The light emitting device package of claim 1, wherein the second molding member (140, 240) has a planar top surface.

4. The light emitting device package of claim 1, wherein the second molding member (141, 143, 145, 241, 243, 245) has a lens-shape top surface.

5. The light emitting device package of claim 1, wherein the light emitting device (120, 220) includes at least one selected from the group consisting of red light emitting device, green light emitting device, blue light emitting device, and white light emitting device..

6. The light emitting device package of claim 1, further comprising a fixing member (161, 261) surrounding the second molding member (145, 245).

7. The light emitting device package of claim 1, further comprising a fluorescent layer (250) disposed over the light emitting device (220).

8. The light emitting device package of claim 1, wherein the light emitting device (120, 220) emits light having a wavelength band of ultraviolet ray.

9. The light emitting device package of claim 1, wherein the light emitting device (120, 220) is disposed in a cavity formed in the package body (110, 210) and the cavity has a step structure corresponding to the step structure between the first (130, 230) and second molding members (140, 141, 143, 145, 240, 241, 243, 245).

10. A light emitting device package comprising:
a package body (310);
a light emitting device (320) over the package body (310);
a resin layer (330) including fluorescent materials, the resin layer (330) at least partially surrounding the light emitting device (320);
a first molding member (340, 341) having a first refractive index over the resin layer (330); and
a second molding member (350, 351, 353, 355, 357, 359) having a second refractive index lower than the first refractive index over the first molding member (340, 341),
wherein the first molding member (340, 341) has a step structure with respect to the second molding member (350, 351, 353, 355, 357, 359).

11. The light emitting device package of claim 10, further comprising a third molding member (371) having a third refractive index lower than the second refractive index over the second molding member (353).

12. The light emitting device package of claim 10, wherein the second molding member (350, 351, 353) has a planar top surface.

13. The light emitting device package of claim 10, wherein the second molding member (355, 357, 359) has a lens-shape top surface.

14. The light emitting device package of claim 10, wherein the fluorescent materials emit light having a different wavelength band from the wavelength band of the light that the light emitting device (320) emits.

15. The light emitting device package of claim 10, wherein the light emitting device (320) emits light having a wavelength band of ultraviolet ray.
